# EUROPEAN PATENT APPLICATION

(11) **EP 0 859 400 A2**
(43) Date of publication of application: **19.08.1998**
(21) Application number: 97310520.8
(22) Date of filing: 23.12.1997
(51) Int. Cl.: H01L 21/027, H01L 21/321, H01L 21/768, G03F 7/00

(54) **Improvements in or relating to integrated circuits**

(30) Priority: 23.12.1996 US 33434 P
(71) Applicant: TEXAS INSTRUMENTS INCORPORATED, Dallas Texas 75265 (US)
(72) Inventor: Yang, Ming, (nmi), Richardson, TX 75082 (US); Li, Lei, (nmi), Richardson, TX 75082 (US); Kaida, Masahiro, Plano, TX 75024 (US)
(74) Representative: Nettleton, John Victor

(57) **Abstract**

A method for plasma etching a buried antireflective coating (BARC) layer. A semiconductor integrated circuit is formed having a layer to be patterned 15 overlying the surface of a semiconductor substrate 11. An organic BARC layer 17 is deposited over the layer to be patterned 15. The organic BARC layer is absorptive of the radiation to be used in a subsequent photoresist expose step. Photoresist layer 19 is formed over the BARC layer 17, exposed to the radiation and patterned to form a desired etch mask. BARC layer 17 prevents unwanted reflections of the incident radiation during the photoresist expose step. BARC layer 17 is then plasma etched in a chemistry including hydrogen bromide (H Br). The plasma etch including (H Br) is selective and has minimal etch bias, providing an excellent vertical etch without etching the underlying layer. After the BARC etch of the invention is completed, the photoresist and BARC layers are used as an etch mask to pattern the underlying layer. The method of the invention may be used to pattern oxides, polysilicon, and glass layers formed of borophosphosilicate glass BPSG. An embodiment for forming a DRAM cell using the method of the invention is described. Other embodiments are described.

## Description

### FIELD OF THE INVENTION

This invention relates generally to the fabrication of integrated circuits utilizing photolithographic techniques and further to the fabrication of etched geometric features on semiconductor circuits using antireflective layers between the photoresist layers and oxides or polysilicon layers to be patterned using etching processes.

### BACKGROUND OF THE INVENTION

In producing integrated circuits with high device density, minimum feature size structures are required for many structures. For example, gates for field effect transistors, small area emitters for bipolar transistors, and narrow interconnection lines for interconnects between structures, transistors and the like. Increasing device density and reducing the minimum feature size is especially important for integrated circuits that act as storage devices, for example in static, dynamic and synchronous random access memory devices (RAMs), read only memory devices (ROMs), electrically erasable programmable ROMs (EEPROMs). These devices require particularly high device densities and therefore the ability to fabricate smaller geometry structures is critical to these applications.

The formation of such structures is typically performed as follows, although this example is only for discussion purposes, and many variations and alternatives are well known to those skilled in the art. First, structures or conductors are defined by depositing a layer of photoresist material over a layer of oxide, polysilicon, BPSG glass or metal which is to be patterned. The photoresist is then exposed by passing light through a reticle mask which defines a particularly desired pattern. After the photoresist is exposed it is developed leaving the resist only in the selected areas. Typically the photoresist is cured or hardened. The photoresist is then used as an etch mask. An anisotropic etch which is selective to the material being patterned is used. The minimum linewidth that can be defined by this etching process is therefore the width of the minimum photoresist line that can be produced using the photoresist process. Current optical steppers expose the photoresist using light having a wavelength of 365 nanometers (nm), (called I-line light after the corresponding emission line in a high-pressure mercury arc lamp used to generate the light ), and pattern linewidths of less than about 0.30 microns with a standard deviation of less than about 0.01 microns cannot be generated satisfactorily using I-line lithography.

In the prior art, it has been discovered that the use of photoresist material over a reflective layer to be patterned, such as for example metal, oxide or polysilicon, creates defects in the photoresist during exposure and development. The photoresist material is applied over structures that are non-planar, some of which are quite high vertically compared to the surrounding areas. When the photoresist is applied, some of the photoresist is thinner than some other areas of the photoresist, depending on the topography of the layer to be patterned. As the photoresist is exposed to the light or energy source, some of the radiation penetrates the photoresist layers and can be reflected back up onto the bottom of the photoresist layer. These reflections cause local differences in the apparent exposure time of the photoresist, resulting in an undesired nonuniformity in the photoresist layer after the development step. The resulting defect in the patterned layer is sometimes called "necking".

In etching methods of the prior art, a layer of antireflective material has been used over the material to be patterned, and underneath the photoresist, to eliminate the necking problem. This layer is sometimes described as a Buried Antireflective Layer (BARL), for example see U.S. Patent No. 5,554,485, or sometimes as a Bottom Antireflective Coating or sometimes as a Backside Antireflective Coating (BARC). The layer is often an organic, for example, a polymer having a low surface energy and perhaps incorporating a dye compound, and absorbing a particular wavelength of energy which roughly matches the wavelength used to expose the photoresist. The BARC layer is used to prevent the incident light from reaching the reflective layer being patterned by the photolithographic process. This prevents the unwanted reflections from the layer to be patterned back into the photoresist, and gives better critical dimension control and thus eliminates "necking".

In the prior art etching process using the BARC or BARL material, after the photoresist material is exposed to the I line light, the unwanted photoresist areas are removed. Next the BARC must be patterned using an etching process where the remaining photoresist acts as an etch mask. Also, after the photoresist is used as an etch mask to pattern the underlying layer, the photoresist and the BARC layer must be removed. One known chemistry for etching the BARC layer is to perform a BARC etch process in a plasma using a chemistry such as follows:

CF₄ + CHF₃ + Ar + O2

This etch will effectively etch the organic BARC layer, however, there are two remaining problems. First, the prior art BARC plasma etch will have an etch bias in the critical dimension, that is, the BARC etch will etch away some area underneath the photoresist pattern. Second, the BARC etches of the prior art will also etch away the bottom film, that is, the etch of the BARC layer also removes part of the layer underneath, typically oxide, borophosphosilicate glass such as BPSG, or polysilicon or silicided polysilicon. This etching of the underlying layer is undesirable as it reduces the controllability of the overall process. In contrast to the known BARC etching systems of the prior art, an optimal plasma BARC etch would be highly selective to the layer being patterned, the oxide or polysilicon layer, without etch bias effects.

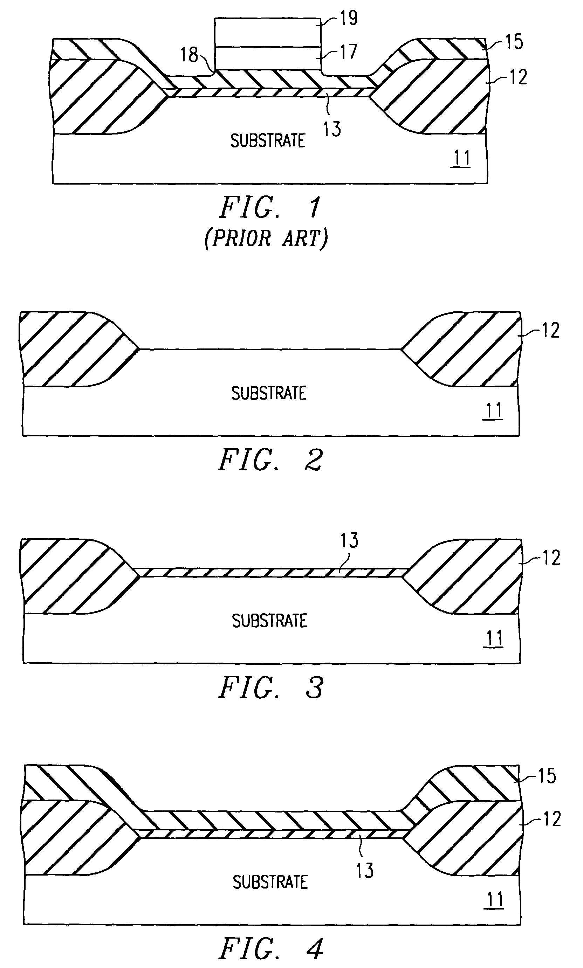

FIG. 1 depicts in cross section an area of a semiconductor device following a typical prior art BARC etch step. In FIG. 1, a semiconductor substrate 11 having a monocrystalline structure and (100) orientation, and typically having p type and n type doped regions formed within it for fabrication of semiconductor devices, is shown. In the exemplary structure of FIG. 1, field oxide regions 12 are provided on the substrate 11 to define a channel region for a transistor. Gate oxide 13 is shown as an example typical structure for such devices. Polysilicon layer 15 is then formed over the gate oxide, to form for example the gate terminal for a MOSFET transistor, as is well known in the art.

The polysilicon layer 15 is to be patterned to form the gate terminal for the exemplary transistor device. In FIG. 1, the BARC layer 17 was sputtered or spun on over the entire device. Photoresist layer 19 was then similarly sputtered or spun on over the entire device. Photoresist layer 19 was then patterned using an optical photomask to define desired patterns. The exposure was performed using I-line radiation. In order to act as an antireflective coating, the BARC layer 17 is chosen of a material that does not reflect the energy being used to expose the photoresist material. In this example, an organic polymer makes an effective BARC layer. Other materials could also be used.

In order to complete the steps performed to make the structure shown in FIG. 1, the photoresist was exposed and then etched, leaving the photoresist region 19. BARC layer 17 was then etched away using the CF₄/CHF₃ plasma chemistry of the prior art.

In FIG. 1, it can be seen that the exposed areas of polysilicon layer 15 has been etched away at the top in areas 17 by the prior art BARC plasma etch. This effect has occurred because the prior art etch process is not completely selective to the BARC layer and etches the polysilicon layer underneath the BARC layer. Further, some critical dimension bias can be seen in FIG. 1 at area 18. The polysilicon has been slightly etched away just under the outer edges of BARC layer 17. Another way to state this is that the prior art BARC etch is not completely anisotropic, it removes some material that should have been left unetched. This creates etch bias effects.

Some work has been done to improve the CF₄ + CHF₃ plasma etch of the prior art by adding CO₂ to the plasma chemistry. These modifications have been found to improve the selectivity to the oxide and polysilicon layers to be patterned. However, the etch bias problem remains, with a typical critical dimension etch bias of about .08 to 1.0 microns. This etch bias is too large for the .35 micron feature sizes of current semiconductor technology. As the minimum feature sizes continue to fall below this level, the critical dimension bias control is even more crucial. Accordingly, a need thus exists for an improved BARC etch chemistry which provides an efficient and highly selective etch with zero etch bias, or an etch bias substantially close to zero. This improved BARC etch is required to maintain a very slight variation in critical dimension across the device being fabricated.

### SUMMARY OF THE INVENTION

Generally, and in one form of the invention, an improved BARC plasma etch chemistry is provided. This etch chemistry is highly selective to oxide and polysilicon films and also provides excellent critical dimension bids. The new chemistry is a plasma etch comprising hydrogen bromide (HBr) , CO₂ and O₂ with Argon or another inert material.

### BRIEF DESCRIPTION OF THE DRAWINGS

The present invention will now be further described by way of example, with reference to the accompanying drawings in which:
FIG. 1 depicts a typical polysilicon gate structure following the BARC plasma etch of the prior art;
FIG. 2 depicts a silicon substrate to he used with the BARC etch of the invention to form a logic device;
FIG. 3 depicts the silicon substrate of FIG. 2 with the gate oxide of a logic device;
FIG. 4 depicts the silicon substrate of FIG. 3 with the polysilicon gate layer to be patterned to form the gate. of a logic device ;
FIG. 5 depicts the silicon substrate of FIG. 4 with the BARC layer of the invention formed over the polysilicon layer to be patterned;
FIG. 6 depicts the silicon substrate of FIG. 5 with the photoresist patterns overlying the BARC layer;
FIG. 7 depicts the silicon substrate of FIG. 6 after the BARC etch process of the current invention;
FIG. 8 depicts across sectional view of a typical one transistor memory storage cell prior to the formation of the capacitor structure;
FIG. 9 depicts the cross section of FIG. 8 after the formation of the BARC layer;
FIG. 10 depicts the cross sectional view of the memory cell of FIG. 9 after the photoresist layer is formed and patterned;
FIG. 11 depicts the cross sectional view of the memory cell of FIG. 10 after the BARC etch of the invention is performed;
FIG. 12 depicts the completed memory cell after the photoresist pattern of FIG. 10 is used as an etch mask to form the storage cell capacitor of the memory cell of FIG. 11.

Corresponding numerals and symbols in the different figures refer to corresponding parts unless otherwise indicated in the specification and the figures.

### DETAILED DESCRIPTION OF PREFERRED EMBODIMENTS

FIG. 2 depicts a silicon substrate 11 which is used as an exemplary structure to describe the operation of the BARC etch of the current invention. Silicon substrate 11 is a monocrystalline layer silicon which typically includes n and p type semiconductor regions which may form, for example the source and drain regions of transistors, or the anodes and or cathodes of diodes, and other implanted regions typically used in the art to form semiconductor devices in silicon substrates. Oxide layers 12 form define a channel region which will be used to depict the formation of a MOSFET transistor gate area, such as might be typically fabricated to form a logic transistor. It should be remembered that the example is merely exemplary and the organic BARC etch method of the invention is not limited to the formation of a transistor or of logic devices, as will be understood by those skilled in the art. The method of the instant invention will provide better results when etching an organic BARC in any application for semiconductor processing where organic BARC or BARL layers are used.

FIG. 3 depicts the silicon substrate of FIG. 2 after the gate oxide 13 is formed over the substrate. The gate oxide is a thin oxide and can be formed using conventionally known techniques, for example it may be deposited or grown.

FIG. 4 depicts the silicon substrate of FIG. 3 after the polysilicon layer 15 is formed. The polysilicon layer 15 is formed by using conventionally known techniques for forming such layers over oxides.

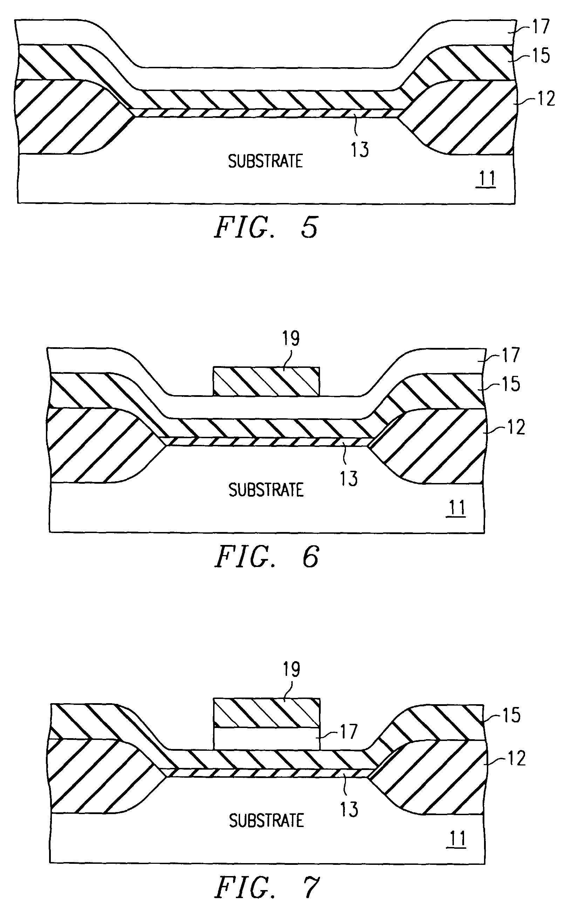

FIG. 5 depicts the silicon substrate of FIG. 4 after the BARC layer 17 is formed. The BARC layer 17 must absorb the incident light being used with the photoresist of the particular system. For I-line light, an organic BARC has been found to form an effective antireflective coating. The BARC layer is typically 1200-2200 Angstroms thick, although many other thicknesses may be used and good results may still be achieved.

FIG. 6 depicts the silicon substrate of FIG. 5 after the photoresist material 19 is formed and patterned using conventional techniques. The photoresist is sputtered on or otherwise deposited. Incident light is used with an optical mask to expose the photoresist and form the desired etch mask that will pattern the polysilicon gate .

FIG. 7 depicts the silicon substrate of FIG. 6 after the BARC plasma etch chemistry of the method of the instant invention is applied. In FIG. 7, BARC layer 17 has been etched using the method of the invention. In one preferred embodiment, an Applied Materials plasma machine was used. The following tables indicate a first preferred method for the BARC etch used to obtain the structure of FIG. 7. A two step plasma etch process is used, first a Main Etch is performed, to remove the majority of the BARC layer, then an Over Etch is performed, to remove remaining BARC while being highly selective to the underlying silicon layer. in a preferred embodiment the following parameters were shown to give excellent results in the Applied Materials plasma etch machine using an organic BARC layer as described above.

### Main Etch Step:

- Pressure: 25 millitorrs
- Power: 300 Watts

| | |
|---|---|
| O2 (sccm) | 10 |
| HBr (sccm) | 10 |
| CO2 (sccm) | 8 |
| Ar (sccm) | 95 |

- Electrode Temperature: 60 degrees Celsius
- Wall Temperature: 40 degrees Celsius
- Etch Time: To Endpoint

### Over Etch Step:

- Pressure:: 25 millitorrs
- Power:: 200 Watts

| | |
|---|---|
| O2 (sccm) | 10 |
| HBr (sccm) | 20 |
| CO2 (sccm) | 8 |
| Ar (sccm) | 95 |

- Electrode Temperature: 60 degrees Celsius
- Wall Temperature: 40 degrees Celsius
- Etch Time:: 50 %

In the embodiment shown above, the results achieved were;
BARC etch rate of 1000 Angstroms/minute
Oxide Etch Rate of 26 Angstroms/minute
Polysilicon Etch Rate of 45 Angstroms/minute

Thus it can be appreciated that the plasma etch method of the instant invention provides the desired selectivity to the underlying layer of either oxide or polysilicon.

In the logic gate example shown above, the critical dimension bias achieved was :
- Isolated logic gate:: -0.007 microns to 0.01 microns
- Dense logic gates:: 0.001 microns to 0.007 microns
The tolerance for the chemistry used for the Main Etch step may be summarized as:

| | |
|---|---|
| O2 | 10 +/- 15% sccm |
| HBr | 10 +/- 15% sccm |
| CO2 | 8 +/- 15% sccm |
| Ar | 95 +/- 15% sccm |

Thus it will be appreciated that the invention herein described includes variations in the materials of the preferred embodiment, each or all of the materials may be varied within +/- 15% and good results still be obtained. Also, the power, electrode temperature, wall temperature, and times may be varied and good results still obtained. It will also be appreciated that the Ar is inert and therefore various substitute materials may be used, for example, Helium or Neon. Other inert substances may also be substituted for the argon (Ar) of the preferred embodiment. Those skilled in the art will recognize that the pressure, temperature and power and equipment used may be varied while still utilizing the instant invention of an organic BARC plasma etch with the HBr/CO2/O2 combined to be highly selective to the underlying layers while providing excellent critical dimension control.

The control of critical dimensions is also required to build advanced memory cells, such as those used for DRAMs. In order to achieve higher density DRAM cells with smaller geometry features, it is necessary to have very tight critical dimension control. This is so because the CD bias causes a variation in the storage cell capacitance value. It is critical to the performance of the DRAM that the storage cells have as close to a uniform capacitance as possible.

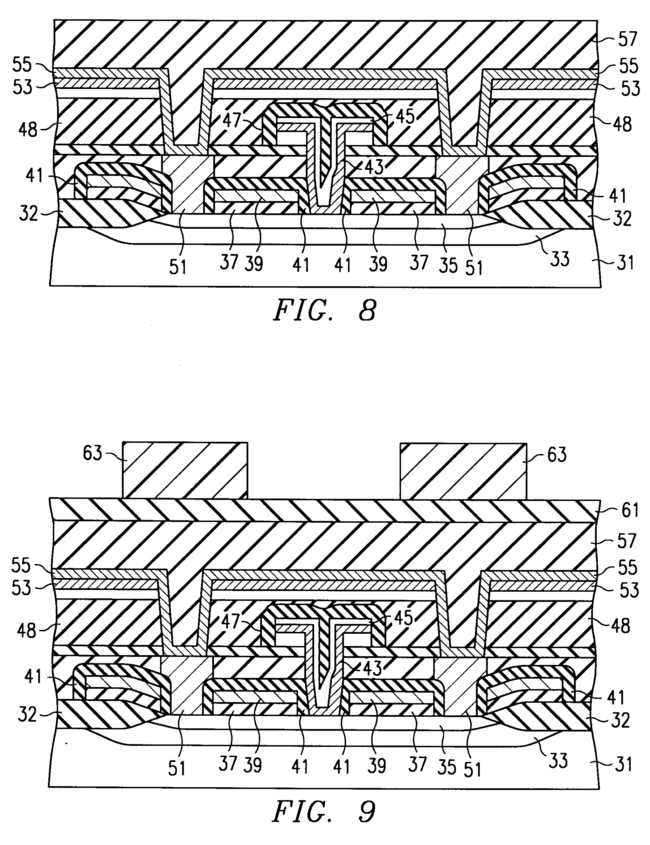

FIG. 8 depicts, in cross section, a portion of partially completed DRAM cell array using a capacitor over bitline structure. In FIG. 8, silicon substrate 31 is provided. A diffusion well Dwell 33 is formed. A memory cell transistor source and drain region is formed in well 35. Field oxide regions 32 define the transistor and cell boundaries. Polysilicon word lines 37 are formed and are typically silicided with a tungsten silicide, Wsiₓ regions 39. The word lines control the gate terminals for the transistors. Nitride layers 41 isolate the word lines from other structures. Oxide layers are formed over the word lines. A bit line is formed of a second level of polysilicon 43 which is also typically silicided with Wsiₓ 45. Another nitride layer is formed over the bit line, layer 47. The bit line contacts down to the source region of the transistor of the DRAM cell, with the word lines overlying the gate regions. Next, a layer of oxide 48 is formed over the bit line structure. This layer of oxide is patterned, and contacts for the capacitor plates are formed. Polysilicon plugs 51 are formed contacting the drain regions of the transistor. Polysilicon layers 53 and 55 are formed to start the formation of the crown cell bottom plate of the capacitor to be formed over the bit line.

In order to form the stacked or crown capacitors used in the capacitor over bitline architecture of the DRAM cell of FIG. 8, a thick layer of borophosphosilicate glass (BPSG) 57 is deposited over the polysilicon plate electrode 55. This BPSG stack will be Used to support a crown structure for the cell plate. After the cell is formed the BPSG will be removed. In order to complete the storage cell capacitor, the BPSG must be pattered into large rectangular areas. This will be done using photoresist patterns and the organic BARC with the process of the instant invention.

FIG. 9 depicts the next step in forming the capacitor over bit line structure for the DRAM cell of FIG. 8. In FIG. 9, over the structure of FIG. 8, BARC layer 61 is formed. This layer is similar to the BARC layer described hereinabove with respect to the logic device of FIGs. 2-7. Photoresist layer 63 is then formed and patterned to leave the pattern for etching the BPSG layer 57. For the DRAM application, the main etch and over etch steps of the process as described above are again applied. The critical dimension results obtained for the DRAM application are described in the X and Y directions, as:
average CD for X = 0.012 microns
average CD for Y = 0.028 microns.

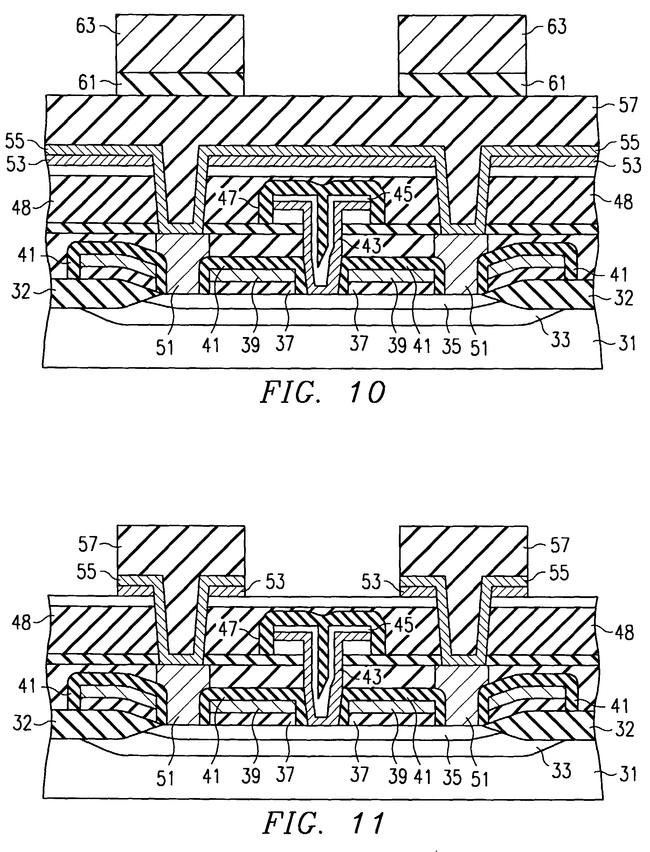

FIG. 10 depicts the resulting BARC structure for the DRAM storage cell after the BARC etch described above. The etch is again highly selective so that no etch of the underlying BPSG layer 57 occurs, and the etch has minimal etch bias so that no etch occurs at the edges of BARC regions 61.

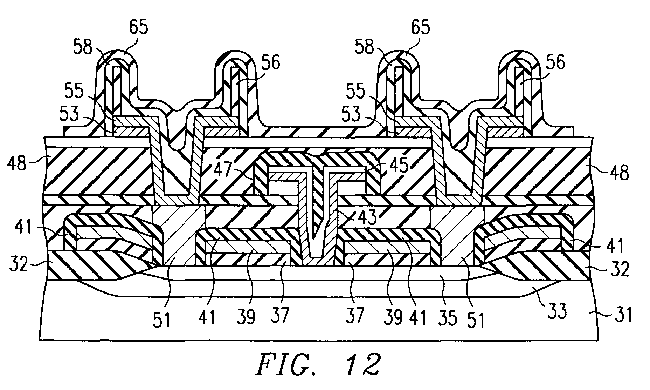

FIG. 11 depicts the resulting BPSG crown structures 57 after the BPSG and polysilicon etch steps which are applied following the BARC etch of the invention. In order to complete the capacitor over bitline crown cells, the BPSG is used to provide sidewall support for an additional polysilicon and silicide layer, which is then patterned and the BPSG removed to form a crown shaped bottom plate for the capacitor. An oxide, nitride, or ONO or other dielectric layer is formed and patterned over the bottom plate, and the finally a polysilicon top plate is formed over the dielectric and coupled to a cell plate voltage. These steps are conventional and well known in the current DRAM art and although not shown, the steps necessary to complete the DRAM cell of FIG. 11 will be understood as using conventional DRAM processing techniques and equipment.

FIG. 12 depicts the completed DRAM cell in cross section. In FIG. 12, sidewalls 56 of polysilicon are formed and patterned on the sides of the BPSG 57 of FIG. 11 and contacting the bottom polysilicon plate 55 of FIG. 11. The BPSG of FIG. 11 is then removed by etching techniques optimized for the BPSG layer 57, and sidewalls 56 and bottom layer 55 form the crown shaped capacitors. A dielectric layer 58 is formed and patterned over the bottom plates and the sidewalls 55 and 56, and then a top polysilicon plate 65 is formed over the capacitors to complete the memory cells.

The method of the invention can be used to pattern any underlying layer where an organic BARC is used to provide an antireflective coating, and is not limited to logic or memory devices as described herein as examples, but has broad applications to semiconductor processing using photolithographic techniques.

While this invention has been described with reference to illustrative embodiments, this description is not intended to be construed in a limiting sense. Various modifications and combinations of the illustrative embodiments, as well as other embodiments of the invention, will be apparent to persons skilled in the art upon reference to the description. It is therefore intended that the appended claims encompass any such modifications or embodiments.

## Claims

1. A method of forming a semiconductor device, comprising the steps of:
forming regions within a substrate of at least a first conductivity type material;
forming a layer to be patterned over said substrate, said layer being reflective of radiation of a first wavelength;
forming a buried anti-reflective coating (BARC) overlying said layer to be patterned, said BARC being absorptive of radiation of said first wavelength;
forming a photoresist layer over said BARC layer, said photoresist layer being exposible by radiation of said first wavelength;
using a photolithographic mask, exposing said photoresist using radiation of said first wavelength, said BARC layer preventing reflections of said radiation back into said photoresist layer;
patterning said photoresist layer to remove the unexposed regions;
plasma etching the BARC layer using the photoresist as an etch mask; and
etching an underlying layer using the photoresist and BARC layers as an etch mask to complete the desired pattern.

2. The method of Claim 1, wherein said step of plasma etching the BARC layer comprises:
providing a plasma etch chemistry including HBr.

3. The method of Claim 1 or Claim 2, wherein said step of plasma etching the BARC layer further comprises:
providing a plasma etch chemistry including HBr, CO2, O2 and an inert molecule.

4. The method of Claim 3, wherein said step of providing a plasma etch chemistry comprises providing a plasma etch chemistry in which said inert molecule is Argon.

5. The method of any of Claims 1 to 3, wherein said step of providing a BARC layer comprises providing an organic BARC layer.

6. The method of any of Claims 1 to 4, wherein said step of etching an underlying layer comprises etching an underlying layer comprising polysilicon layer.

7. The method of any of Claims 1 to 4, wherein said step of etching an underlying layer comprises etching an underlying layer comprising an oxide layer.

8. The methd of any of Claims 1 to 4, wherein said step of etching an underlying layer comprises etching an underlying layer comprising borophosposilicate glass (BPSG).
